# EUROPEAN PATENT APPLICATION

(11) **EP 4 512 854 A1**
(43) Date of publication of application: **26.02.2025**
(21) Application number: 23275126.3
(22) Date of filing: 24.08.2023
(51) Int. Cl.: C08J 9/42, C08J 9/00, H05K 9/00

(54) **RADAR-ABSORBENT MATERIAL AND METHODS OF MANUFACTURE THEREOF**

(71) Applicant: MBDA UK Limited, Stevenage, Hertfordshire SG1 2DA (GB)
(72) Inventor: The designation of the inventor has not yet been filed
(74) Representative: BAE SYSTEMS plc Group IP Department

(57) **Abstract**

A radar-absorbent material (201) and a method (100) of producing such a radar-absorbent material (201) is disclosed. The radar-absorbent material (201) comprises a radar-absorbent foam (200). The radar-absorbent foam (200) comprises a plurality of pores (202) wherein said pores (202) are defined by one or more interior surfaces (204) of the radar-absorbent foam (200). The method comprising applying (102) a parylene coating (212) to at least one of said interior surfaces (204).

## Description

### FIELD

The present invention relates to radar-absorbent material (RAM) and methods of manufacturing such material.

### BACKGROUND

One known type of RAM is radar-absorbent foam (also known as foam absorbers). Typically, radar-absorbent is a foam (for example a polyurethane foam) loaded with conductive particles, for example carbon. Examples of such commercially available radar-absorbent foams include the Laird ^{™} Eccosorb ^{™} product range.

Radar-absorbent foams are often prone to shedding (e.g. losing small chunks of foam during cutting, abrasion and/or impact) and/or highly compressible. This may give rise to various issues during manufacture and subsequent use. For example, foams are often difficult to accurately shape and/or dimensionally inspect post-shaping. Shedding may lead to contamination of machinery and surrounding areas. In use, the tendency to shed may lead to a degradation in radar absorbing properties (particularly when complex shapes are required) and/or create a foreign object debris risk for surrounding areas. Radar-absorbent foams may also be difficult to secure to surfaces, particularly when using adhesives, as the foams deform under pressure. This may make it difficult to apply an appropriate level of pressure and/or increase the risk of damage to the foam during assembly. It would be advantageous to provide a radar-absorbent foam and/or method of manufacturing such a foam where these issues are reduced and/or eliminated.

In order to reduce the risk of shedding in use, it is known to apply a polyurethane layer to the exterior of the radar-absorbent foam after it has been shaped into its final form. However, this does not address many of the issues that arise during manufacture prior to final shaping.

Additionally or alternatively, it would be advantageous to provide an improved radar-absorbent foam and/or method of manufacturing such a foam.

### SUMMARY

According to an aspect of the present invention, there is provided a method of producing a radar-absorbent material. The radar-absorbent material comprises a radar-absorbent foam. The radar-absorbent foam comprises a plurality of pores. Said pores are defined by one or more interior surfaces of the radar-absorbent foam. The method comprises applying a parylene coating to at least one of said interior surfaces.

Applying a parylene coating to the interior surface(s) of the radar-absorbent foam may reduce shedding and/or the compressibility of the foam, thereby facilitating manufacture and/or assembly, without impacting on the radar-absorbing characteristics of the foam. Additionally and/or alternatively, this improvement may be achieved without needing to alter the material composition of the radar-absorbing foam and/or using commercially available parylene materials.

An interior surface defines, in whole or in part, a pore of the foam. The radar-absorbent material/radar-absorbent foam may comprise one or more outer surfaces being the exposed surfaces of the foam. It will be appreciated that in the case that a pore opens onto the exterior of the foam, part of the interior surface defining said pore may form part of the outer surface of the foam. The method may comprise applying a parylene coating to at least one outer surface of the foam. For example, the method may comprise simultaneously or sequentially applying a parylene coating to the interior and/or outer surface(s) of the foam.

It will be understood that parylene refers to thermoplastic polymers and/or copolymers of para-xylene and/or substituted para-xylene monomers. Examples of suitable parylene materials include parylene C, parylene N, parylene D and parylene AF-4, and combinations thereof.

It will be appreciated that a parylene coating consists primarily, for example (substantially) consists, of parylene material.

It may be that the parylene is adsorbed onto said interior surface(s) to form a layer. It may be that the parylene coating is a layer of parylene material on said interior surface(s).

The method may comprise applying the parylene coating and then shaping the radar-absorbent foam/the radar-absorbent material. The presence of the coating on the interior surfaces of the radar-absorbent foam may facilitate shaping of the material/foam and/or (in contrast to coatings that are only applied to the exterior of the foam) allow the benefits in terms of reduced shedding and/or compressibility to persist after shaping without the need for further applications of coating. Additionally or alternatively, the method may comprise shaping the radar-absorbent foam/the radar-absorbent material, and then applying the parylene coating.

Shaping the radar-absorbent foam/the radar-absorbent material may comprise cutting or using other subtractive manufacturing process to remove a portion of the radar-absorbent foam and/or alter the shape of the foam. The step of shaping the radar-absorbent foam/material may comprise forming one or more recesses in an outer surface of the foam/material and/or altering the cross-sectional shape of the foam/material.

It may be that said parylene coating is applied to said at least one interior surface by chemical vapour deposition. The use of chemical vapour deposition may allow the parylene coating to penetrate within the interior of the foam and thereby reach the interior surfaces. Conventional parameters for the chemical vapour deposition process for various parylene materials, including parylene C, parylene N, parylene D and parylene AF-4, will be known to the skilled person.

The radar-absorbent foam may be a porous material. The radar-absorbent foam may comprise one or more internal surfaces, each internal surface defining in whole or in part one or more pores. The radar-absorbent foam may be an open-cell foam. The radar-absorbent foam may be a reticulated foam. The radar-absorbent foam may comprise a plurality of interconnected pores and/or open-cell pores. The radar-absorbent foam may be a polymer foam, for example a polyurethane foam. The radar-absorbent foam may comprise a plurality of conductive particles, for example conductive carbon black particles. The conductive particles may be distributed within, for example throughout, the foam. The distribution of conductive particles may be inhomogeneous within the foam. For example, it may be that the concentration of conductive particles per unit volume of foam increases with distance from an outer surface of the foam, for example continually increases with distance from one side of the foam to the other. Any reference to foam herein shall be taken to be a reference to radar-absorbent foam unless otherwise stated. Examples of such foams include the Laird ^{™} Eccosorb ^{™} product range.

The method may comprise applying a parylene coating to the majority of, for example (substantially) all of, said interior surfaces. It may be that said radar-absorbent foam has an interior surface area being the sum of the surface area of the interior surfaces of the radar-absorbent foam. The method may comprise applying said parylene coating such that said parylene coating covers the majority, for example at least 70 percent, for example at least 95 percent of the interior surface area of said foam.

The method may comprise applying a parylene coating to form a parylene layer having a thickness of between 1 µm and 25 µm, for example between 5 µm and 20 µm, for example between 10 µm and 20 µm, for example between 10 µm and 15 µm over the majority of, for example (substantially) all of, the surface area of the parylene coating. The thickness of the parylene coating at a given location may be defined as the extent of the coating measured in a direction normal to the interior surface at that location.

Prior to any shaping step, the radar-absorbent foam may be in the form of a sheet, for example a sheet having a length, a width and a thickness wherein the thickness is very much less than the length and the width. It may be that the sheet has a thickness of between 3 mm and 20 mm, for example between 5 mm and 20 mm over the majority of, for example (substantially) all of, the surface area of the sheet. The thickness of the sheet may be substantially constant over the majority of, for example (substantially) all of, the surface area of the sheet.

In a second aspect of the invention there is provided a radar-absorbent material comprising a radar-absorbent foam, the radar-absorbent foam comprising: a plurality of pores defined by one or more interior surfaces of the radar-absorbent foam; and a parylene coating on at least one of said internal surfaces.

The radar-absorbent material, radar-absorbent foam and/or parylene coating may have any of the features described above with respect to the first aspect.

It may be that said radar-absorbent material has a parylene coating on the majority of, for example (substantially) all of, said interior surfaces. It may be that said radar-absorbent foam has an interior surface area being the sum of the surface area of the interior surfaces of the radar-absorbent foam. It may be that said parylene coating covers the majority, for example at least 70 percent, for example at least 95 percent, for example (substantially) all of the interior surface area of said foam.

It may be that the parylene coating forms a layer on said inner surface(s). It may be that the layer has a thickness of between 1 µm and 25 µm, for example between 5 µm and 20 µm, for example between 10 µm and 20 µm, for example between 10 µm and 15 µm over the majority of, for example (substantially) all of, the surface area of the parylene coating.

It may be that said radar-absorbent material is in the form of a sheet having a thickness very much less than its width and length.

Where a numerical range is given herein, that range is inclusive of the end points unless otherwise stated. Thus, by way of example, a thickness of between 1 µm and 25 µm includes a thickness of 1 µm and a thickness of 25 µm.

It will of course be appreciated that features described in relation to one aspect of the present invention may be incorporated into other aspects of the present invention. For example, the method of the invention may incorporate any of the features described with reference to the apparatus of the invention and vice versa.

### BRIEF DESCRIPTION OF THE FIGURES

Embodiments of the invention will now be described by way of example only with reference to the figures, in which:
Figure 1 shows a flow chart of an example method in accordance with the present disclosure;
Figure 2 (a) shows a cross-sectional view of a portion of radar-absorbent material in accordance with a first example embodiment of the invention;
Figure 2 (b) shows a close-up of a region of Figure 2 (a) after a parylene coating has been applied to the interior surfaces;
Figure 3 (a) shows a cross-sectional view of a portion of radar-absorbent material in accordance with a second example embodiment of the invention; and
Figure 3 (b) shows the radar-absorbent material of Figure 3 (a) after a shaping step.

### DETAILED DESCRIPTION

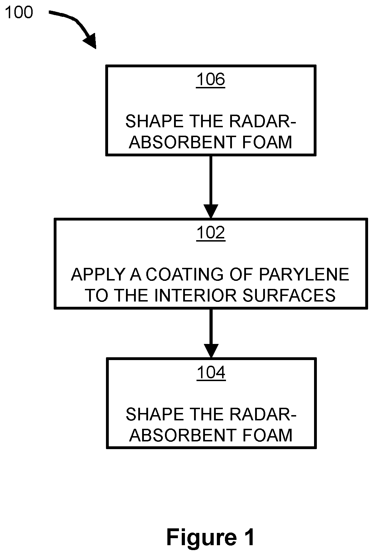

Figure 1 shows a flow chart of a method 100 of manufacturing a RAM in accordance with the present disclosure. The method comprises applying 102 a coating of parylene to the at least one interior surface, for example the majority of the interior surfaces, of a radar-absorbent foam. Optionally, the parylene is applied using chemical vapour deposition. In some embodiments, the radar-absorbent foam is shaped 104 after applying 102 the coating of parylene. In the same or yet further embodiments, the radar-absorbent foam is shaped 106 before applying 102 the coating of parylene. The step(s) of shaping 104,106 may comprise cutting or using other subtractive manufacturing process to remove a portion of the radar-absorbent foam.

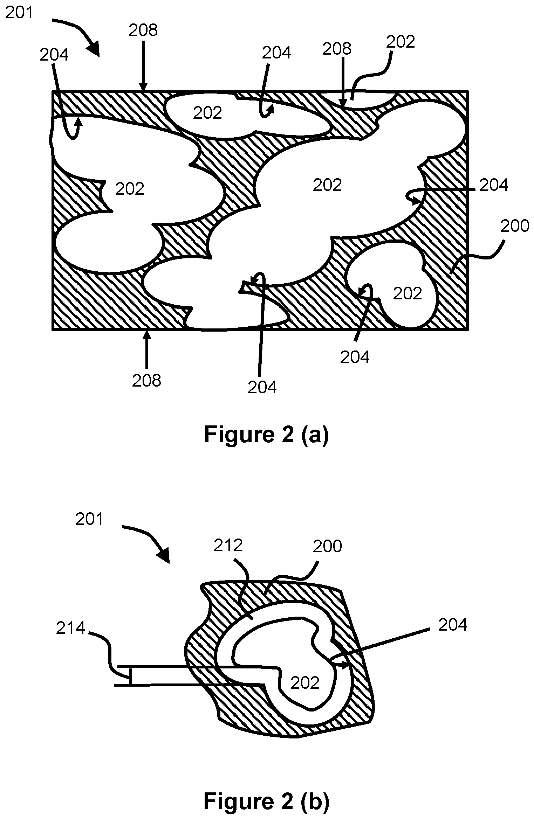

Figure 2 (a) shows a cross-sectional view of a portion of a RAM 201 in accordance with a first example embodiment. The RAM 201 comprises a radar-absorbent foam 200 having formed within it a plurality of interconnected open-cell pores 202 defined by interior surfaces 204. In other embodiments the foam may have a reticulated structure, wherein the pores defined by interior surfaces are very much more open than shown in Figure 2(a). The foam 200 also comprises outer surfaces 208 being the exposed surfaces of the foam 200. In some embodiments, the foam 200 may be in the form of a sheet having a thickness very much less than its length and width. In other embodiments the foam 200 may have a more block-like shape. The foam 200 has an interior surface area being the total surface area of interior surfaces 204.

Figure 2 (b) shows a close-up view of a portion of the RAM 201 of Figure 2 (a) after a coating of parylene has been applied in accordance with the present disclosure. Like reference numerals are used to indicate like elements, for example 204 refers to the interior surfaces in both Figure 2 (a) and Figure 2(b). In Figure 2 (b) a parylene coating 212 has formed a layer on the interior surfaces 204 of the pores 202. It will be appreciated that although not shown in Figure 2(b) in some embodiments the parylene coating 212 will also be present on the outer surfaces 208 of the foam 200. In the embodiment of Figure 2(b) the parylene coating 212 extends over the whole of the interior surface area of the pore 202. In some embodiments, the parylene coating 212 may extend over substantially the whole of the interior surface area of the foam 200. In some embodiments, the parylene coating 212 may extend over the majority of, but not the whole of, the interior surface area of the foam 200. The parylene coating 212 has a thickness 214 which, at any given location, is the extent of the coating in the direction normal to the interior surface. In some embodiments, the thickness 214 may be around 15 µm across the entire surface of the parylene coating. In some embodiments, the parylene coating 212 is a coating of parylene-C. In other embodiments, the parylene coating 212 is a coating of parylene N, parylene D, or parylene AF-4, or combinations thereof.

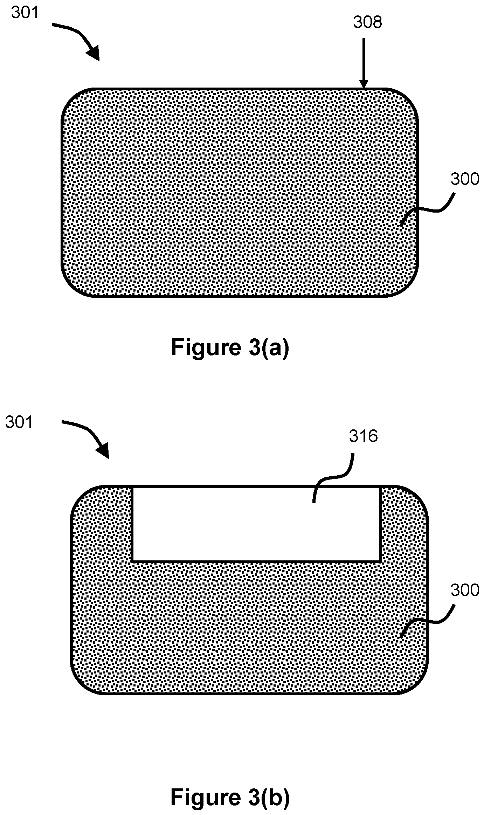

Figures 3 (a) and (b) show a cross-sectional view through a portion of RAM 301, for example as shown in Figures 2(a) and 2(b). The RAM 301 comprises a radar absorbent foam 300 and a parylene coating, however the scale of magnification differs as between Figures 2 and 3 such that individual pores of the RAM 301 appear only as dots in figure 3. It will be appreciated in any event that all figures herein are highly schematic, and Figures 2 and 3 are not scaled reproductions of one another. Like reference numerals are used to indicate like elements as between Figures 2 and 3. In Figure 3 (a) the RAM 301 has a rectangular cross-section. In Figure 3 (b) the RAM 301/foam 300 has been shaped to create a recess 316 in the uppermost outer surface 308. It will be appreciated that various differently shaped recesses may be created in one or more of the surfaces. In the same or yet further embodiments, the foam 300 may be shaped to define one or more protrusions in one or more surfaces and/or such that the material has a different shape from that shown in Figure 3.

In one example, a coating of parylene C was applied to the internal and external surfaces of a radar-absorbing foam using chemical vapour deposition. The parylene C coating had a thickness of 15 µm throughout the foam. The presence of the parylene C coating had no significant impact on the radar-absorbent properties of the foam but was found to significantly reduce shedding and the compressibility of the foam, thereby facilitating shaping and assembly.

## Claims

1. A method (100) of producing a radar-absorbent material, the radar-absorbent material (201) comprising a radar-absorbent foam (200), the radar-absorbent foam (200) comprising a plurality of pores (202) wherein said pores (202) are defined by one or more interior surfaces (204) of the radar-absorbent foam (200), the method comprising applying (102) a parylene coating (212) to at least one of said interior surfaces (204).

2. The method (100) according to claim 1, comprising applying (102) the parylene coating (212) and then shaping (104) the radar-absorbent foam (200).

3. The method (100) according to claim 1 or claim 2, wherein said parylene coating (212) is applied to said at least one interior surface (104) by chemical vapour deposition.

4. The method (100) according to any previous claim, wherein said radar-absorbent foam (200) is a polyurethane foam having with a plurality of conductive particles distributed within the foam.

5. The method (100) according to any previous claim, wherein said radar-absorbent foam (200) is an open-celled foam.

6. The method (100) according to any previous claim, wherein said radar-absorbent foam (200) has an interior surface area being the sum of the surface area of the interior surfaces (204) of the radar-absorbent foam (200), and wherein the method comprises applying (102) a parylene coating (212) to the majority, for example at least 70 percent, for example at least 95 percent, for example substantially all, of the interior surface area of said foam.

7. The method (100) according to any previous claim, wherein the method comprises applying (102) a parylene coating (212) having a thickness (214) of between 5 µm and 25 µm, for example between 5 µm and 20 µm, for example between 10 µm and 20 µm, for example between 10 µm and 15 µm over the majority of, for example substantially all of, the surface area of the parylene coating (212).

8. The method (100) according to any previous claim, wherein prior to any shaping step (104, 106), said radar-absorbent foam (200) is a sheet having a minimum dimension of between 3 mm and 20 mm, for example between 5 mm and 20 mm.

9. The method (100) according to any previous claim, wherein the parylene is one of parylene C, parylene N, parylene D, parylene AF-4, or combinations thereof

10. A radar-absorbent material (201) comprising a radar-absorbent foam (200), the radar-absorbent foam (200) comprising:
a plurality of pores (202) defined by one or more interior surfaces (104) of the radar-absorbent foam (200); and
a parylene coating (212) on at least one of said internal surfaces (104).

11. The radar-absorbent material (201) according to claim 10, wherein said radar-absorbent foam (200) has an interior surface area being the sum of the surface area of the interior surfaces (204) of the radar-absorbent foam, and wherein said parylene coating (212) covers the majority, for example at least 70 percent, for example at least 95 percent, for example substantially all of the interior surface area of the foam.

12. The radar-absorbent material (201) according to any of claims 10 and 11, wherein said radar-absorbent foam (200) is a polyurethane foam having plurality of conductive particles distributed within the foam.

13. The radar-absorbent material (201) according to any of claims 10 to 12, wherein said radar-absorbent foam (200) is an open-celled foam, for example a reticulated foam.

14. The radar-absorbent material (201) according to any of claims 10 to 13, where said radar-absorbent material is in the form of a sheet having a thickness very much less than its width and length.

15. The radar-absorbent material (201) according to any of claims 10 to 14, wherein the parylene is one of parylene C, parylene N, parylene D, parylene AF-4, or combinations thereof.
